# EUROPEAN PATENT SPECIFICATION

(11) **EP 2 706 094 B1**
(45) Date of publication and mention of the grant of the patent: **10.02.2016**
(21) Application number: 11865434.2
(22) Date of filing: 28.11.2011
(51) Int. Cl.: C08L 77/12, C08J 5/18, G02B 5/08, G02F 1/13357

(54) **REFLECTOR AND LIGHT EMITTING DEVICE COMPRISING SAME**
REFLEKTOR UND LICHTEMITTIERENDE VORRICHTUNG DAMIT
RÉFLECTEUR ET DISPOSITIF ÉLECTROLUMINESCENT COMPRENANT LEDIT RÉFLECTEUR

(30) Priority: 06.05.2011 KR 20110043071
(43) Date of publication of application: 12.03.2014
(73) Proprietor: Shenzhen Wote Advanced Materials Co., Ltd., Nanshan District, Shenzhen (CN)
(72) Inventor: HAMADA, Kenji, Daejeon 302-120 (KR); LEE, Youn Eung, Daejeon 301-152 (KR); LEE, Jin Kyu, Busan 617-774 (KR); OH, Young Taek, Seoul 121-842 (KR); KIM, Mahn Jong, Daejeon 305-761 (KR)
(74) Representative: Kador & Partner
(86) International application number: PCT/KR2011/009103
(87) International publication number: WO 2012/153900

(56) References cited:
- EP-A1- 1 760 104
- EP-B1- 0 779 338
- WO-A1-2006/025546
- WO-A1-2008/143455
- JP-A- 2004 339 462
- KR-A- 20080 041 132
- KR-A- 20100 135 540
- KR-A- 20100 135 542
- US-A- 6 046 300
- US-A1- 2010 053 972

## Description

### TECHNICAL FIELD

The present invention relates to a reflector and a light-emitting device including the same, and more particularly, to a reflector including a wholly aromatic liquid crystalline polyester amide resin compound that includes a repeating unit derived from a hydroxybenzoic acid, a repeating unit derived from a hydroxynaphthoic acid, and a repeating unit derived from an aminobenzoic acid, but does not include a repeating unit derived from an aromatic dicarboxylic acid and a light-emitting device including the same.

### BACKGROUND ART

Polyamide-based resins that are efficiently used in injection molding have been widely used to manufacture reflectors, such as a reflector for a light-emitting diode (LED) or an organic electro luminescence (EL) display device. However, polyamide-based resins discolor or polymers decompose in a light-emitting device, such as an LED, which operates at a high voltage, when exposed to light and heat for a long period of time. Thus, the polyamide-based resins may not properly function as a reflector, may deteriorate the emission capability of light-emitting devices, and may reduce a lifespan thereof.

A wholly aromatic liquid crystalline polyester resin (LCP) that is drawing attention as a new material for reflectors has high thermal resistance and micromolding thereof may be possible. However, conventional wholly aromatic liquid crystalline polyester resins cannot form an injection-molded product that has a dense structure, so that cracks may often occur in the surface of the product, and provides less initial reflectance than the polyamide-based resins. In particular, reflectance rapidly decreases in the initial stage of reliability evaluation. If the wholly aromatic liquid crystalline polyester resin is used in a reflector of a light-emitting body used in an internal or external light or a backlight unit for a TV which should be stable against light and heat for a long period of time, the brightness or saturation of a screen may become unstable. US 2010/0053972 relates to wholly aromatic liquid crystal polyesters and their use in LEDs.

### DETAILED DESCRIPTION OF THE INVENTION

### TECHNICAL PROBLEM

The present invention provides a reflector including a wholly aromatic liquid crystalline polyester amide resin compound that includes a repeating unit derived from a hydroxybenzoic acid, a repeating unit derived from a hydroxynaphthoic acid, and a repeating unit derived from an aminobenzoic acid, but does not include a repeating unit derived from an aromatic dicarboxylic acid.

The present invention also provides a light-emitting device including the reflector.

### TECHNICAL SOLUTION

According to an aspect of the present invention, there is provided a reflector including a wholly aromatic liquid crystalline polyester amide resin compound that includes a repeating unit derived from a hydroxybenzoic acid, a repeating unit derived from a hydroxynaphthoic acid, and a repeating unit derived from an aminobenzoic acid, but does not include a repeating unit derived from an aromatic dicarboxylic acid, wherein the wholly aromatic liquid crystalline polyester amide resin compound further includes a white inorganic filler.

The hydroxybenzoic acid may be selected from the group consisting of p-hydroxybenzoic acid, 3-hydroxybenzoic acid, 2-hydroxybenzoic acid, and any combinations thereof.

The hydroxynaphthoic acid may be selected from the group consisting of 6-hydroxy-2-naphthoic acid, 3-hydroxy-2-naphthoic acid, 2-hydroxy-1-naphthoic acid, 1-hydroxy-2-naphthoic acid and any combinations thereof.

The aminobenzoic acid may be selected from the group consisting of anthranilic acid, 3-aminobenzoic acid, 4-aminobenzoic acid, and any combinations thereof.

The wholly aromatic liquid crystalline polyester amide resin may include 65 to 85 parts by mol of the sum of the repeating unit derived from a hydroxybenzoic acid and the repeating unit derived from an aminobenzoic acid and 15 to 35 parts by mol of the repeating unit derived from a hydroxynaphthoic acid.

The wholly aromatic liquid crystalline polyester amide resin may include 50 to 84.5 parts by mol of the repeating unit derived from a hydroxybenzoic acid, 0.5 to 15 parts by mol of the repeating unit derived from an aminobenzoic acid, and 15 to 35 parts by mol of the repeating unit derived from a hydroxynaphthoic acid.

The white inorganic filler may include titanium oxide.

An amount of the white inorganic filler may be in a range of 10 to 60 parts by weight based on 100 parts by weight of the wholly aromatic liquid crystalline polyester amide resin compound.

The wholly aromatic liquid crystalline polyester amide resin compound may further include at least one of a glass fiber and wollastonite.

According to another aspect of the present invention, there is provided a light-emitting device including the reflector described above.

The light-emitting device may be a light-emitting diode (LED) or an organic electro luminescence (EL) display device.

### ADVANTAGEOUS EFFECTS

According to the one or more embodiments of the present invention, a reflector includes a wholly aromatic liquid crystalline polyester amide resin compound that includes a repeating unit derived from a hydroxybenzoic acid, a repeating unit derived from a hydroxynaphthoic acid, and a repeating unit derived from an aminobenzoic acid, but does not include a repeating unit derived from an aromatic dicarboxylic acid, whereby the reflector has high whiteness, initial reflectance of the reflector is less reduced, and discoloration of the reflector caused by light and heat may be prevented.

In addition, a light-emitting device including the reflector may have a high emission capability and a long lifespan.

### BEST MODE

Hereinafter, exemplary embodiments of the present invention will be described in detail.

As used herein, the term "and/or" includes any and all combinations of one or more of the associated listed items. Expressions such as "at least one of," when preceding a list of elements, modify the entire list of elements and do not modify the individual elements of the list.

A reflector according to an embodiment of the present invention will be described.

The reflector used herein refers to an object that adjusts the brightness of light emitted from a light-emitting device such as a light emitting diode (LED) or an organic electro luminescence (EL) display device by using reflection of light.

The reflector includes a wholly aromatic liquid crystalline polyester amide resin compound that includes a repeating unit derived from a hydroxybenzoic acid, a repeating unit derived from a hydroxynaphthoic acid, and a repeating unit derived from an aminobenzoic acid, but does not include a repeating unit derived from an aromatic dicarboxylic acid.

The wholly aromatic liquid crystalline polyester amide resin compound does not discolor even when exposed to light and heat for a long period of time due to the intrinsic properties of the wholly aromatic liquid crystalline polyester amide resin that is a main component of the wholly aromatic liquid crystalline polyester amide resin compound, so that a reflector including the wholly aromatic liquid crystalline polyester amide resin compound has high whiteness and excellent durability. In addition, the initial reflectance decline of the reflector including the wholly aromatic liquid crystalline polyester amide resin compound is reduced. In addition, an emission capability of the light-emitting device including the reflector lasts for a long period of time, and thus, the lifespan of the light-emitting device increases.

The wholly aromatic liquid crystalline polyester amide resin may include 65 to 85 parts by mol of the sum of the repeating unit derived from a hydroxybenzoic acid and the repeating unit derived from an aminobenzoic acid and 15 to 35 parts by mol of the repeating unit derived from a hydroxynaphthoic acid. If the total amount of the repeating unit derived from a hydroxybenzoic acid and the repeating unit derived from an aminobenzoic acid and the amount of the repeating unit derived from a hydroxynaphthoic acid are within the ranges described above, the wholly aromatic liquid crystalline polyester amide resin may be efficiently prepared and may have sufficient whiteness for the reflector, high anti-discoloration property at a high temperature, and high physical strength. In addition, the wholly aromatic liquid crystalline polyester amide resin compound may be efficiently used in injection molding since it is not well released, does not break well, and dust is not well generated therefrom during the injection molding.

In particular, the wholly aromatic liquid crystalline polyester amide resin may include 50 to 84.5 parts by mol of the repeating unit derived from a hydroxybenzoic acid, 0.5 to 15 parts by mol of the repeating unit derived from an aminobenzoic acid, and 15 to 35 parts by mol of the repeating unit derived from a hydroxynaphthoic acid. When the amounts of the repeating unit derived from a hydroxybenzoic acid, the repeating unit derived from an aminobenzoic acid, and the repeating unit derived from a hydroxynaphthoic acid are within the ranges described above, the wholly aromatic liquid crystalline polyester amide resin may be efficiently prepared and may have sufficient whiteness for the reflector, high anti-discoloration property at a high temperature.

The wholly aromatic liquid crystalline polyester amide resin used in the preparation of the wholly aromatic liquid crystalline polyester amide resin compound may be prepared according to the following steps:
(a) Synthesizing a wholly aromatic liquid crystalline polyester amide prepolymer by condensation polymerizing at least one monomer; and
(b) Synthesizing a wholly aromatic liquid crystalline polyester amide resin by solid phase condensation polymerizing the prepolymer.

The monomer used in step (a) includes: hydroxybenzoic acid selected from the group consisting of p-hydroxybenzoic acid, 3-hydroxybenzoic acid, 2-hydroxybenzoic acid, and any combinations thereof; hydroxynaphthoic acid selected from the group consisting of 6-hydroxy-2-naphthoic acid, 3-hydroxy-2-naphthoic acid, 2-hydroxy-1-naphthoic acid, 1-hydroxy-2-naphthoic acid and any combinations thereof; and aminobenzoic acid selected from the group consisting of anthranilic acid, 3-aminobenzoic acid, 4-aminobenzoic acid, and any combinations thereof, but does not include aromatic dicarboxylic acid such as isophthalic acid, 2,6-naphthalene dicarboxylic acid, terephthalic acid, and phthalic acid.

In addition, metal acetate may further be used as a catalyst that facilitates the synthesis of the wholly aromatic liquid crystalline polyester amide prepolymer. The metal acetate may include at least one selected from the group consisting of magnesium acetate, potassium acetate, calcium acetate, zinc acetate, manganese acetate, lead acetate, antimony acetate, and cobalt acetate. The amount of the metal acetate may be 0.10 parts by weight or less based on 100 parts by weight of the monomer.

The synthesis of step (a) may be performed using melt condensation polymerization or bulk condensation polymerization. In addition, a monomer (i.e., acylated monomer) that has reactivity enhanced by pre-treatment with chemicals such as an acylating agent (particularly, acetylating agent) may be used in step (a) in order to facilitate the condensation polymerization.

For the solid phase condensation polymerization in step (b), the prepolymer is required to be heated using, for example, a heating plate, hot air, hot fluid, or the like. By-products produced during the solid phase condensation polymerization may be removed by purging the reactor with inert gas or by applying vacuum thereto.

The wholly aromatic liquid crystalline polyester amide resin compound may further include a white inorganic filler as an additive. The wholly aromatic liquid crystalline polyester amide resin compound may further include a glass fiber and/or wollastonite. The white inorganic filler improves whiteness of the wholly aromatic liquid crystalline polyester amide resin compound, so that the reflectance of the reflector including the resin compound may be increased. In addition, the glass fiber improves the mechanical strength of the reflector including the wholly aromatic liquid crystalline polyester amide resin compound without reducing the reflectance of the reflector. The wollastonite prevents surface roughness of the resin compound, which may increase due to the glass fiber, from being increased and also prevents the adhesive property of the resin compound, which may decrease due to the glass fiber, from being reduced.

The white inorganic filler may include titanium oxide, for example, titanium dioxide.

In addition, the amount of the white inorganic filler may be in the range of 10 to 60 parts by weight, for example, 30 to 60 parts by weight, based on 100 parts by weight of the wholly aromatic liquid crystalline polyester amide resin compound. If the amount of the white inorganic filler is in the range of 10 to 60 parts by weight based on 100 parts by weight of the wholly aromatic liquid crystalline polyester amide resin compound, an injection-molded product that has high whiteness, tensile strength, and flexural strength may be manufactured.

The amount of the glass fiber may be in the range of 5 to 50 parts by weight based on 100 parts by weight of the wholly aromatic liquid crystalline polyester amide resin compound. If the amount of the glass fiber is within the range described above, injection-molded products have sufficient self supporting force, so that the yield of the resin compound increases, injection-molded products have suitable elasticity, so that the injection-molded products do not break, and the glass fiber is uniformly dispersed in injection-molded products, so that a short shot is not occured and the injection-molded products have uniform strength.

The amount of the wollastonite may be in the range of 5 to 40 parts by weight based on 100 parts by weight of the wholly aromatic liquid crystalline polyester amide resin compound. If the amount of the wollastonite is within the range described above, injection-molded products have low surface roughness, high strength, and sufficient self supporting force, so that the yield of the resin compound increases.

The wholly aromatic liquid crystalline polyester amide resin compound may be prepared by mixing the wholly aromatic liquid crystalline polyester amide resin, the white inorganic filler, and optionally the glass fiber and/or wollastonite at a predetermined ratio, and melt-kneading and drying the mixture. In the melt-kneading, a batch kneader, a twin-screw extruder, or a mixing roll may be used. In addition, a lubricant, such as a fluoro-based lubricant, may be used during the melt-kneading for smooth melt-kneading.

The wholly aromatic liquid crystalline polyester amide, resin compound may be injection-molded into reflectors having various shapes such as a circle, a plate, a cup, or a lampshade having a thickness in the range of 0.1 to 100 mm using a pressure or speed control type injection molding machine. During the injection molding, the wholly aromatic liquid crystalline polyester amide resin compound is insert injection-molded into a frame or sole injection-molded. The reflector prepared according to the above process may be used in a light-emitting device such as an LED.

One or more embodiments will now be described in detail with reference to the following examples. However, these examples are not intended to limit the purpose and scope of the invention.

### Examples

### Preparation Example 1-1: Preparation of wholly aromatic liquid crystalline polyester amide resin 1

2,983 g (21.6 mol) of p-hydroxybenzoic acid, 1,298 g (6.9 mol) of 6-hydroxy-2-naphthoic acid, and 206 g (1.5 mol) of 4-aminobenzoic acid, and 0.3 g of potassium acetate, as a catalyst, were added to a 10 L batch reactor, the temperature of which is controllable. Nitrogen gas was injected to the reactor to inactivate the inside of the reactor, and then 3,247 g (31.8 mol) of acetic anhydride was added thereto. Then, the temperature of the reactor was increased up to 150°C for 30 minutes and the hydroxy group of the monomers was acetylated at 150°C for 2 hours. Then, the temperature of the reactor was increased up to 300°C for 5 hours and 20 minutes while removing acetic acid that is produced during the acetylation and maintained at this temperature for 60 minutes to prepare a wholly aromatic liquid crystalline polyester amide prepolymer 1 by condensation polymerization of the monomers. Acetic acid, which is a by-product of the preparation of the wholly aromatic liquid crystalline polyester amide prepolymer 1, was also continuously removed during the preparation of the wholly aromatic liquid crystalline polyester amide prepolymer 1 with the acetic acid produced during the acetylation. Then, the wholly aromatic liquid crystalline polyester amide prepolymer 1 was collected from the reactor and cooled and solidified.

Then, the wholly aromatic liquid crystalline polyester amide prepolymer 1 was ground to have an average particle diameter of 1 mm, and 3.2 kg of the ground wholly aromatic liquid crystalline polyester amide prepolymer 1 was added to a 10 L rotary kiln reactor. The temperature of the reactor was increased up to 200°C where weight loss is initiated for 1 hour while flowing nitrogen at a rate of 1 Nm³/hr. Then, the temperature was maintained at 200°C for 2 hours and 30 minutes, increased up to 280°C for 5 hours and maintained at 280°C for 4 hours to prepare a wholly aromatic liquid crystalline polyester amide resin 1. Then, the reactor was cooled to room temperature for 1 hour, and the wholly aromatic liquid crystalline polyester amide resin 1 was collected from the reactor.

### Preparation Examples 1-2 through 1-6: Preparation of wholly aromatic liquid crystalline polyester amide resins

Wholly aromatic liquid crystalline polyester amide resins 2 through 6 were prepared in the same manner as in Preparation Example 1-1, except that p-hydroxybenzoic acid, 6-hydroxy-2-naphthoic acid, and 4-aminobenzoic acid were used in the amounts shown in Table 1 below.

**<Table 1 >**

| | Amount of monomer | | |
|---|---|---|---|
| | p-hydroxybenzoic acid | 6-hydroxy-2-naphthoic acid | 4-aminobenzoic acid |
| Preparation Example 1-2 | 2,901 g (21.0 mol) | 1,411 g (7.5 mol) | 206 g (1.5 mol) |
| Preparation Example 1-3 | 2,486 g (18.0 mol) | 1,694 g (9.0 mol) | 411 g (3.0 mol) |
| Preparation Example 1-4 | 3,191 g (23.1 mol) | 1,298 g (6.9 mol) | 0 g (0.0 mol) |
| Preparation Example 1-5 | 3,108 g (22.5 mol) | 1,411 g (7.5 mol) | 0 g (0.0 mol) |
| Preparation Example 1-6 | 2,486 g (23.1 mol) | 1,298 g (6.9 mol) | 0 g (0.0 mol) |

### Preparation Example 2-1: Preparation of wholly aromatic liquid crystalline polyester amide resin compound 1

The wholly aromatic liquid crystalline polyester amide resin 1 prepared according to Preparation Example 1-1, a glass fiber (Sungjin Fiber Co., Ltd, MF150W-AC) having a length in the range of 100 to 300 µm, an average length of 150 µm, and a diameter of 10±1 µm, and titanium oxide (Dupont, T-Pure R-105) coated with UV-stable alumina, silica, and a hydrophobic organic compound were mixed in a weight ratio of 5:1:4 using a batch type mixer (Jeil Industry Device Co., Ltd.) for 30 minutes. Then, the mixture was dried in an oven dryer (ASung Plant) at 130°C for 4 hours or more to reduce its moisture content to 200 wtppm or less and melt-kneaded while quantitatively feeding at a rate of 10 kg/hr using a twin extruder (L/D: 40, diameter: 25 mm) to prepare a wholly aromatic liquid crystalline polyester amide resin compound 1. In order to remove gas and by-products produced during the melt-kneading, one open vent unit and one vacuum vent unit were respectively installed at No. 3 and No. 7 barrel units of the twin extruder. The prepared wholly aromatic liquid crystalline polyester amide resin compound 1 was cooled using a cooling system (Seawon M-tech Co., Ltd., mesh conveyer belt), moisture was removed, and the resultant was pelletized. Then, the prepared pellets of the wholly aromatic liquid crystalline polyester amide resin compound 1 were dried using an automatic dryer (Jeil Industry Device Co., Ltd.) for 2 hours and mixed.

### Preparation Example 2-2: Preparation of wholly aromatic liquid crystalline polyester amide resin compound 2

Wholly aromatic liquid crystalline polyester amide resin compound 2 was prepared in the same manner as in Preparation Example 2-1, except that the wholly aromatic liquid crystalline polyester amide resin 2 prepared according to Preparation Example 1-2 was used instead of the wholly aromatic liquid crystalline polyester amide resin 1 of Preparation Example 1-1.

### Preparation Example 2-3: Preparation of wholly aromatic liquid crystalline polyester amide resin compound 3

Wholly aromatic liquid crystalline polyester amide resin compound 3 was prepared in the same manner as in Preparation Example 2-1, except that the wholly aromatic liquid crystalline polyester amide resin 3 prepared according to Preparation Example 1-3 was used instead of the wholly aromatic liquid crystalline polyester amide resin 1 of Preparation Example 1-1.

### Preparation Example 3-1: Preparation of wholly aromatic liquid crystalline poolyester resin compound 1

Wholly aromatic liquid crystalline polyester resin compound 1 was prepared in the same manner as in Preparation Example 2-1, except that the wholly aromatic liquid crystalline polyester amide resin 4 prepared according to Preparation Example 1-4 was used instead of the wholly aromatic liquid crystalline polyester amide resin 1 of Preparation Example 1-1.

### Preparation Example 3-2: Preparation of wholly aromatic liquid crystalline polyester resin compound 2

Wholly aromatic liquid crystalline polyester resin compound 2 was prepared in the same manner as in Preparation Example 2-1, except that the wholly aromatic liquid crystalline polyester amide resin 5 prepared according to Preparation Example 1-5 was used instead of the wholly aromatic liquid crystalline polyester amide resin 1 of Preparation Example 1-1.

### Preparation Example 3-3: Preparation of wholly aromatic liquid crystalline polyester resin compound 3

Wholly aromatic liquid crystalline polyester resin compound 3 was prepared in the same manner as in Preparation Example 2-1, except that the wholly aromatic liquid crystalline polyester amide resin 6 prepared according to Preparation Example 1-6 was used instead of the wholly aromatic liquid crystalline polyester amide resin 1 of Preparation Example 1-1.

### Examples 1 through 3: Preparation of reflectors 1 through 3 for LED

Each of the wholly aromatic liquid crystalline polyester amide resin compounds prepared according to Preparation Examples 2-1 through 2-3 were dried using an oven dryer (ASung Plant) at 130°C for 4 hours or more to reduce a moisture content thereof to 200 wtppm or less. Then, planar reflectors 1 through 3 having a thickness of 2 mm, a width of 50 mm, and a length of 50 mm were prepared using an electric injection molding machine (Sodick, TR30EH2). In this case, the inside of the injection molding machine was cleaned by 200 injections, and 100 samples of each reflector were collected.

### Comparative Examples 1 through 3: Preparation of reflectors 4 through 6 for LED

Reflectors 4 through 6 for LED were respectively prepared in the same manner as in Examples 1 through 3, except that the wholly aromatic liquid crystalline polyester resin compounds prepared according to Preparation Examples 3-1 through 3-3 were respectively used instead of the wholly aromatic liquid crystalline polyester amide resin compounds prepared according to Preparation Examples 2-1 through 2-3.

### Evaluation Example

### Evaluation of performances of reflectors 1 through 6 for LED

The effect of improving initial reflectance decline of the reflectors 1 to 6 for LEDs each prepared according to Examples 1 to 3 and Comparative Examples 1 to 3 was evaluated.

### (Effect of improving the Initial reflectance Decline)

Reflectance of each reflector was measured right after injection molding using a color difference meter (Konica Minolta, CM-3700d). Samples of each reflector were added to a sealed space in which a xenon lamp having a rated output of 50 W, a maximum luminous flux of 5,000 lumen, and a color temperature of 4,300 K (Polarion, PS-PH) was installed, the reflectance of each reflector was measured 6 hours after the injection molding to evaluate the effect of improving the initial reflectance decline. As the reflectance is less changed with time, the effect of improving the initial reflectance increases. That is, reflectances of 5 samples of each reflector for an LED were measured in a wavelength ranging from 360 to 740 nm at every 10 nm interval using the color difference meter, and an average value thereof was calculated and the average value at 450, 550 and 650 nm at which a standard reflectance is measured was indicated as reflectance. Here, the measurement range of reflectance ranged from 0 to 100%, and a standard deviation of the reflectance was 0.1% or less. Evaluation results of the effect of improving the initial reflectance decline are shown in Table 2 below.

**<Table 2>**

| | Initial reflectance (%) | | | Reflectance 6 hours after injection molding (%) | | | Reflectance difference (%) (reflectance 6 hours after injection molding - initial reflectance) | | |
|---|---|---|---|---|---|---|---|---|---|
| | 450nm | 550nm | 650nm | 450nm | 550nm | 650nm | 450nm | 550nm | 650nm |
| Example 1 | 79.4 | 86.7 | 85.3 | 79.2 | 84.8 | 83.0 | -0.2 | -1.9 | -2.3 |
| Example 2 | 78.4 | 86.3 | 88.6 | 78.0 | 84.8 | 87.2 | -0.4 | -1.5 | -1.4 |
| Example 3 | 78.6 | 85.8 | 88.2 | 77.2 | 83.5 | 86.1 | -1.4 | -2.3 | -2.1 |
| Comparative Example 1 | 77.8 | 86.0 | 88.7 | 75.9 | 83.5 | 85.5 | -1.9 | -2.5 | -3.2 |
| Comparative Example 2 | 77.4 | 84.4 | 89.0 | 75.2 | 81.9 | 86.2 | -2.2 | -2.5 | -2.8 |
| Comparative Example 3 | 78.4 | 86.4 | 89.0 | 76.9 | 83.9 | 86.0 | -1.5 | -2.5 | -3.0 |

Referring to Table 2, the effects of improving the initial reflectance decline of the reflectors for LEDs each prepared according to Examples 1 to 3 were higher than those of the reflectors for LEDs each prepared according to Comparative Examples 1 to 3 over the whole wavelength range. In this regard, as the reflectance difference decreases, the effect of improving the initial reflectance decline increases. When a commercially available display device including the reflector that has high effect of improving the initial (i.e., within 6 hours) reflectance decline is used as it is (that is, a 'brightness' mode is automatically set) or used after the brightness mode is manually set, a reduction in brightness does not notably occur within a short period of time and thus there is no need to reset the brightness mode. Accordingly, it may prevent a decrease in consumer confidence.

As described above, according to the one or more embodiments of the present invention, a reflector includes a wholly aromatic liquid crystalline polyester amide resin compound that includes a repeating unit derived from a hydroxybenzoic acid, a repeating unit derived from a hydroxynaphthoic acid, and a repeating unit derived from an aminobenzoic acid, but does not include a repeating unit derived from an aromatic dicarboxylic acid, whereby the reflector has high whiteness, initial reflectance of the reflector is less reduced, and discoloration of the reflector caused by light and heat may be prevented.

In addition, a light-emitting device including the reflector may have a high emission capability and a long lifespan.

## Claims

1. A reflector comprising a wholly aromatic liquid crystalline polyester amide resin compound that comprises a repeating unit derived from a hydroxybenzoic acid, a repeating unit derived from a hydroxynaphthoic acid, and a repeating unit derived from an aminobenzoic acid, but does not comprise a repeating unit derived from an aromatic dicarboxylic acid,
wherein the wholly aromatic liquid crystalline polyester amide resin compound further comprises a white inorganic filler.

2. The reflector of claim 1, wherein the hydroxybenzoic acid is selected from the group consisting of p-hydroxybenzoic acid, 3-hydroxybenzoic acid, 2-hydroxybenzoic acid, and any combinations thereof, the hydroxynaphthoic acid is selected from the group consisting of 6-hydroxy-2-naphthoic acid, 3-hydroxy-2-naphthoic acid, 2-hydroxy-1-naphthoic acid, 1-hydroxy-2-naphthoic acid and any combinations thereof, and the aminobenzoic acid is selected from the group consisting of anthranilic acid, 3-aminobenzoic acid, 4-aminobenzoic acid, and any combinations thereof.

3. The reflector of claim 1, wherein the wholly aromatic liquid crystalline polyester amide resin comprises 65 to 85 parts by mol of the sum of the repeating unit derived from a hydroxybenzoic acid and the repeating unit derived from an aminobenzoic acid and 15 to 35 parts by mol of the repeating unit derived from a hydroxynaphthoic acid.

4. The reflector of claim 3, wherein the wholly aromatic liquid crystalline polyester amide resin comprises 50 to 84.5 parts by mol of the repeating unit derived from a hydroxybenzoic acid, 0.5 to 15 parts by mol of the repeating unit derived from an aminobenzoic acid, and 15 to 35 parts by mol of the repeating unit derived from a hydroxynaphthoic acid.

5. The reflector of claim 1, wherein the white inorganic filler comprises titanium oxide.

6. The reflector of claim 1, wherein an amount of the white inorganic filler is in a range of 10 to 60 parts by weight based on 100 parts by weight of the wholly aromatic liquid crystalline polyester amide resin compound.

7. The reflector of claim 5, wherein the wholly aromatic liquid crystalline polyester amide resin compound further comprises at least one of a glass fiber and wollastonite.

8. A light-emitting device comprising the reflector according to claim 1

9. The light-emitting device of claim 8, wherein the light-emitting device is a light-emitting diode (LED) or an organic electro luminescence (EL) display device.

## Patentansprüche

1. Reflektor umfassend eine gänzlich aromatische flüssigkristalline Polyesteramidharzverbindung, die eine Wiederholungeinheit, die von einer Hydroxybenzoesäure abgeleitet ist, eine Wiederholungseinheit, die von einer Hydroxynaphthoesäure abgeleitet ist, und eine Wiederholungseinheit, die von einer Aminobenzoesäure abgeleitet ist, umfasst, wobei sie aber keine Wiederholungseinheit umfasst, die von einer aromatischen Dicarbonsäure abgeleitet ist,
wobei die gänzlich aromatische flüssigkristalline Polyesteramidharzverbindung ferner einen weißen anorganischen Füllstoff umfasst.

2. Reflektor nach Anspruch 1, wobei die Hydroxybenzoesäure aus der Gruppe ausgewählt ist, bestehend aus p-Hydroxybenzoesäure, 3-Hydroxybenzoesäure, 2-Hydroxybenzoeäure und irgendwelchen Kombinationen davon, die Hydroxynaphthoesäure aus der Gruppe ausgewählt ist, bestehend 6-Hydroxy-2-naphthoesäure, 3-Hydroxy-2-naphthoesäure, 2-Hydroxy-1-naphthoesäure, 1-Hydroxy-2-naphthoesäure und irgendwelchen Kombinationen davon, und die Aminobenzoesäure aus der Gruppe ausgewählt ist, bestehend Anthranilsäure, 3-Aminobenzoesäure, 4-Aminobenzoesäure und irgendwelchen Kombinationen davon.

3. Reflektor nach Anspruch 1, wobei das gänzlich aromatische flüssigkristalline Polyesteramidharz 65 bis 85 Mol-Anteile von der Summe aus der Wiederholungeinheit, die von einer Hydroxybenzoesäure abgeleitet ist, der Wiederholungseinheit, die von einer Aminobenzoesäure abgeleitet ist, und 15 bis 35 Mol-Anteile von der Wiederholungseinheit, die von einer Hydroxynaphthoesäure abgeleitet ist, umfasst.

4. Reflektor nach Anspruch 3, wobei das gänzlich aromatische flüssigkristalline Polyesteramidharz 50 bis 84,5 Mol-Anteile von der Wiederholungeinheit, die von einer Hydroxybenzoesäure abgeleitet ist, 0,5 bis 15 Mol-Anteile von der Wiederholungseinheit, die von einer Aminobenzoesäure abgeleitet ist, und 15 bis 35 Mol-Anteile von der Wiederholungseinheit, die von einer Hydroxynaphthoesäure abgeleitet ist, umfasst.

5. Reflektor nach Anspruch 1, wobei der weiße anorganische Füllstoff Titanoxid umfasst.

6. Reflektor nach Anspruch 1, wobei eine Menge für den anorganischen Füllstoff in einem Beriech von 10 bis 60 Gewichtsanteilen liegt, basierend auf 100 Gewichtsanteilen von der gänzlich aromatischen flüssigkristallinen Polyesteramidharzverbindung.

7. Reflektor nach Anspruch 5, wobei die gänzlich aromatische flüssigkristalline Polyesteramidharzverbindung ferner mindestens einen aus einer Glasfaser und Wollastonit umfasst.

8. Lichtemittierende Vorrichtung, umfassend den Reflektor nach Anspruch 1.

9. Lichtemittierende Vorrichtung nach Anspruch 8, wobei die lichtemittierende Vorrichtung eine lichtemittierende Diode (LED) oder eine organische elektrolumineszente (EL)-Display-Vorrichtung ist.

## Revendications

1. Réflecteur comprenant un composé de résine polyester amide cristalline liquide entièrement aromatique qui comprend une unité de répétition dérivée d'un acide hydroxybenzoïque, une unité de répétition dérivée d'un acide hydroxynaphthoïque, et une unité de répétition dérivée d'un acide aminobenzoïque, mais qui ne comprend pas d'unité de répétition dérivée d'un acide dicarboxylique aromatique ;
dans lequel le composé de résine polyester amide cristalline liquide entièrement aromatique comprend en outre une charge inorganique blanche.

2. Réflecteur selon la revendication 1, dans lequel l'acide hydroxybenzoïque est sélectionné dans le groupe constitué par un acide p - hydroxybenzoïque, un acide 3 - hydroxybenzoïque, un acide 2 - hydroxybenzoïque, et par n'importe quelle association de ceux-ci, l'acide hydroxynaphthoïque est sélectionné dans le groupe constitué par un acide 6 - hydroxy - 2 - naphthoïque, un acide 3 - hydroxy - 2 - naphthoïque, un acide 2 - hydroxy - 1 - naphthoïque, un acide 1 - hydroxy - 2 - naphthoïque, et par n'importe quelle association de ceux-ci, et l'acide aminobenzoïque est sélectionné dans le groupe constitué par un acide anthranilique, un acide 3 - aminobenzoïque, un acide 4 - aminobenzoïque, et par n'importe quelle association de ceux-ci.

3. Réflecteur selon la revendication 1, dans lequel la résine polyester amide cristalline liquide entièrement aromatique, comprend entre 65 parties et 85 parties par mole de la somme de l'unité de répétition dérivée d'un acide hydroxybenzoïque et de l'unité de répétition dérivée d'un acide aminobenzoïque, et entre 15 parties et 35 parties par mole de l'unité de répétition dérivée d'un acide hydroxynaphthoïque.

4. Réflecteur selon la revendication 3, dans lequel la résine polyester amide cristalline liquide entièrement aromatique, comprend entre 50 parties et 84,5 parties par mole de l'unité de répétition dérivée d'un acide hydroxybenzoïque, entre 0,5 parties et 15 parties par mole de l'unité de répétition dérivée d'un acide aminobenzoïque, et entre 15 parties et 35 parties par mole de l'unité de répétition dérivée d'un acide hydroxynaphthoïque.

5. Réflecteur selon la revendication 1, dans lequel la charge inorganique blanche comprend de l'oxyde de titane.

6. Réflecteur selon la revendication 1, dans lequel la quantité de charge inorganique blanche se situe dans une plage comprise entre 10 parties et 60 parties en poids sur la base de 100 parties en poids du composé de résine polyester amide cristalline liquide entièrement aromatique.

7. Réflecteur selon la revendication 5, dans lequel le composé de résine polyester amide cristalline liquide entièrement aromatique, comprend en outre au moins l'une d'une fibre de verre et d'une wollastonite.

8. Dispositif électroluminescent comprenant le réflecteur selon la revendication 1.

9. Dispositif électroluminescent selon la revendication 8, dans lequel le dispositif électroluminescent est une diode électroluminescente (LED) ou un dispositif d'affichage électroluminescent organique (EL).
